# EUROPÄISCHE PATENTSCHRIFT

(11) **EP 3 236 483 B1**
(45) Veröffentlichungstag und Bekanntmachung des Hinweises auf die Patenterteilung: **13.02.2019**
(21) Anmeldenummer: 17000628.2
(22) Anmeldetag: 12.04.2017
(51) Int. Cl.: H01H 9/54, B25F 5/00, H02P 1/02, A01G 3/053, B23B 45/02

(54) **VERFAHREN UND VORRICHTUNG ZUR ERKENNUNG DER SCHALTSTELLUNG EINES BETRIEBSSCHALTERS ZUR INBETRIEBNAHME EINES ELEKTROMOTORS**
METHOD AND DEVICE FOR DETECTING THE SWITCHING POSITION OF AN OPERATING SWITCH FOR PUTTING AN ELECTRIC MOTOR INTO OPERATION
PROCÉDÉ ET DISPOSITIF DE DÉTECTION DE LA POSITION DE COMMUTATION D'UN COMMUTATEUR DE FONCTIONNEMENT POUR LA MISE EN SERVICE D'UN MOTEUR ÉLECTRIQUE

(30) Priorität: 14.04.2016 DE 102016004525
(43) Veröffentlichungstag der Anmeldung: 25.10.2017
(73) Patentinhaber: Andreas Stihl AG & Co. KG, 71336 Waiblingen (DE)
(72) Erfinder: Gurr, Kay-Steffen, 74078 Heilbronn (DE); Liebhard, Gernot, 71332 Waiblingen (DE); Klöker, Jens, 71729 Erdmannhausen (DE); Siller, Jochen, 71638 Ludwigsburg (DE); Leufen, Heinrich, 71409 Schwaikheim (DE)
(74) Vertreter: Wasmuth, Rolf

(56) Entgegenhaltungen:
- EP-A2- 2 484 494
- EP-A2- 2 671 681
- WO-A1-2015/147331
- US-A1- 2004 228 065
- US-A1- 2010 109 441

## Beschreibung

Die Erfindung betrifft ein Verfahren sowie eine Vorrichtung zur Erkennung der Schaltstellung eines Betriebsschalters zur Inbetriebnahme eines Elektromotors.

Es sind Verfahren bekannt, mit denen der Elektromotor über eine Ansteuerschaltung in Betrieb genommen wird. Hierzu ist der Elektromotor über eine Ansteuerschaltung mit einer Spannungsquelle verbunden, wobei der Betriebsschalter zwischen der Ansteuerschaltung und der Spannungsquelle angeordnet ist. Der Betriebsschalter schaltet die Versorgungsspannung auf die Ansteuerschaltung, die daraufhin den angeschlossenen Elektromotor in Betrieb nimmt.

Wird der Betriebsschalter geöffnet, läuft der Elektromotor aus. Während des Motorauslaufs liegt aufgrund der generatorischen Motorspannung des auslaufenden Elektromotors an der Ansteuerschaltung weiter Spannung an. Auch nach dem Stillstand des Elektromotors wird aufgrund der bestehenden Kapazitäten der Elektronik für weitere 1-2 Sekunden Spannung an der Ansteuerungselektronik anliegen. Erst nach Unterschreiten einer minimalen Versorgungsspannung von z. B. 5 V geht die Elektronik in einen Zustand über, aus dem sie nur über ein Reset wieder in Betrieb gehen kann, sobald erneut eine ausreichende Versorgungsspannung an der Elektronik anliegt.

Um einen störungssicheren Betrieb des Elektromotors zu gewährleisten, muss die Elektronik der Ansteuerschaltung den Zustand des Betriebsschalters kennen. Da die an der Ansteuerspannung anliegende Spannung aufgrund der generatorischen Motorspannung beim Auslaufen des Elektromotors keine eindeutige Erkennung eines geschlossenen Betriebsschalters gewährleistet, wird meist ein zusätzlicher Kontakt im Betriebsschalter genutzt. Über diesen zusätzlichen Kontakt erhält die Ansteuerschaltung die Information über den Schaltzustand des Betriebsschalters.
Zum Einschalten eines Elektromotors über eine Ansteuerschaltung sind regelmäßig Betriebsschalter mit einem zusätzlichen Kontakt für die Erkennung des Schaltzustands des Betriebsschalters notwendig, die konstruktiv aufwendig und daher kostenintensiv sind. Fällt der zusätzliche Kontakt für die Erkennung des Schaltzustands des Betriebsschalters aus, ist ein ordnungsgemäßer Betrieb des Elektromotors nicht gewährleistet.

Dokument WO2015/147331 offenbart eine Erkennung der Schaltstellung eines Betriebsschalters zur Inbetriebnahme eines Elektromotors, der über eine Ansteuerschaltung mit einer Spannungsquelle verbunden ist. Es offenbart weiter, dass nach einem Einschalten des Betriebsschalters die Eingangsspannung der Ansteuerschaltung überwacht wird, dass ein Mittelwert der Eingangsspannung ermittelt wird, und dass der ermittelte Mittelwert der Eingangsspannung mit einem vorgegebenen Grenzwert verglichen wird.

Der Erfindung liegt die Aufgabe zugrunde, den Betriebsschalter zur Inbetriebnahme eines Elektromotors über eine Ansteuerschaltung einfacher und damit kostengünstiger auszubilden, dennoch aber in jedem Betriebszustand einen sicheren Betrieb des Elektromotors über die Ansteuerschaltung zu gewährleisten.
Die Aufgabe wird mit einem Verfahren nach dem Anspruch 1 gelöst.
Eine Vorrichtung zur Erkennung der Schaltstellung eines Betriebsschalters zur Inbetriebnahme eines Elektromotors ist im Anspruch 10 wiedergegeben.
Gemäß dem erfindungsgemäßen Verfahren wird nach einem Abschalten des Elektromotors die Eingangsspannung der Ansteuerschaltung überwacht. Dies ist grundsätzlich auch nach dem Ausschalten des Betriebsschalters für eine begrenzte Zeitspanne möglich, da aufgrund der generatorischen Motorspannung und von in der Elektronik verbauten Kondensatoren und/oder Spulen die Ansteuerschaltung für einen begrenzten Zeitraum weiter funktionsfähig bleibt.

Gemäß der Erfindung wird nach dem Abschalten des Elektromotors und dem Wiedereinschalten des Betriebsschalters der Gradient eines Spannungsanstiegs der an der Ansteuerschaltung anliegenden Eingangsspannung ermittelt. Dieser ermittelte Gradient des Spannungsanstiegs wird mit einem vorgegebenen Grenzwert verglichen. Dabei kann bei Überschreiten des vorgegebenen Grenzwertes darauf geschlossen werden, dass der Betriebsschalter geschlossen ist. Wird der Betriebsschalter als geschlossen erkannt, wird der Elektromotor über die Ansteuerschaltung erneut in Betrieb genommen, so dass ein rasches und sicheres Wiederanlaufen des Elektromotors erzielt ist.

Nach der Erfindung ist der Gradient des Spannungsanstiegs der Indikator für den Schaltzustand des Betriebsschalters. Dadurch kann auf einen zusätzlichen Schaltkontakt zur Erkennung des Schaltzustandes des Betriebsschalters verzichtet werden, was die Konstruktion des Betriebsschalters vereinfacht. Ferner entfällt eine ansonsten notwendige Verdrahtung des zusätzlichen Schaltkontakts zur Ansteuerschaltung. Der Gradient des Spannungsanstiegs wird als verlässliche Information über den Schaltzustand des Betriebsschalters genutzt.

Eine erneute Inbetriebnahme des Elektromotors erfolgt regelmäßig nach einem Öffnen des Betriebsschalters. Nach dem Öffnen des Betriebsschalters wird die Eingangsspannung an der Ansteuerschaltung abfallen. Die Ansteuerschaltung ist aber nicht sofort stromlos, sondern bleibt auch bei abfallender Eingangsspannung für einen begrenzten Zeitraum funktionsfähig. Nach einem erneuten Betätigen des Betriebsschalters (Betriebsschalter geschlossen) wird die Eingangsspannung der Ansteuerschaltung ansteigen. Ist der Gradient des Spannungsanstiegs größer als ein vorgegebener Grenzwert, erkennt die Ansteuerschaltung den geschlossenen Betriebsschalter anhand des ermittelten Gradienten und kann den Elektromotor durch entsprechende Ansteuerung sofort wieder in Betrieb nehmen.

Sinkt nach einem Abschalten des Elektromotors und einem Öffnen des Betriebsschalters die Eingangsspannung an der Ansteuerschaltung unter einen vorgegebenen Grenzwert, so wird zum Wiedereinschalten des Elektromotors gefordert, dass ein erneutes Wiedereinschalten erst bei Spannungswerten der Eingangsspannung erfolgt, die oberhalb des vorgegebenen Grenzwertes liegen. Der Elektromotor wird erst dann in Betrieb genommen, wenn ein Gradient des Spannungsanstiegs der Eingangsspannung oberhalb eines vorgegebenen Grenzwertes liegt und die Eingangsspannung der Ansteuerschaltung oberhalb eines vorgegebenen Grenzwertes liegt.

Es hat sich als zweckmäßig erwiesen, wenn das Überschreiten des ermittelten Gradienten des Spannungsanstiegs über den vorgegebenen Grenzwert und das Überschreiten des vorgegebenen Spannungswertes innerhalb eines vorgegebenen Zeitfensters liegen. Nur wenn diese beiden Bedingungen innerhalb des Zeitfensters erfüllt werden, wird der Elektromotor in Betrieb genommen.

Das Zeitfenster erstreckt sich zweckmäßig über einen Zeitraum von 80 bis 200 Millisekunden. Vorteilhaft ist das Zeitfenster mit 100 Millisekunden bemessen.

Wird innerhalb des Zeitfensters nur eine der beiden genannten Bedingungen erfüllt, wird die Ansteuerschaltung resettet.

Vorteilhaft ist vorgesehen, dass der Spannungsanstieg der Eingangsspannung erst nach Ablauf einer Pausenzeit nach dem Abschalten des Elektromotors ermittelt wird. Dadurch wird gewährleistet, dass ein Spannungsanstieg aufgrund der elektrochemischen Erholung des Akkus nicht zu einem Wiederanlaufen des Elektromotors führen kann. Zweckmäßig ist vorgesehen, dass die Pausenzeit größer als die Erholzeit des Akkus gewählt wird.

Die Auslegung der elektrischen Schaltung zur Durchführung des erfindungsgemäßen Verfahrens ist so vorgesehen, dass nach dem Öffnen des Betriebsschalters die Eingangsspannung der Ansteuerschaltung über einen Zeitraum von 1 bis 4 Sekunden unter einen vorgegebenen Grenzwert abfällt.

Die erfindungsgemäße Vorrichtung zur Erkennung der Schaltstellung eines Betriebsschalters zur Inbetriebnahme eines Elektromotors ist derart ausgebildet, dass der Elektromotor über die Ansteuerschaltung mit einer Spannungsquelle verbunden ist. Der Betriebsschalter ist zwischen der Ansteuerschaltung und der Spannungsquelle angeordnet und schaltet die Versorgungsspannung der Spannungsquelle als Eingangsspannung auf die Ansteuerschaltung. Es ist eine Überwachungsvorrichtung vorgesehen, an der die Eingangsspannung der Ansteuerschaltung anliegt. Die Überwachungsvorrichtung überwacht einen Gradienten des Spannungsanstiegs der Eingangsspannung und vergleicht den ermittelten Gradienten mit einem vorgegebenen Grenzwert. Wird der vorgegebene Grenzwert überschritten, ist dies der Indikator für einen geschlossenen Betriebsschalter. Bei Überschreiten des vorgegebenen Grenzwertes kann somit der Betriebsschalter als geschlossen erkannt werden. Die Überwachungsvorrichtung wird bei Erkennen eines geschlossenen Betriebsschalters ein Startsignal an die Ansteuerschaltung übermitteln, worauf diese den Elektromotor erneut in Betrieb nimmt.

Um die elektrochemische Regeneration eines Akkus nach Abschalten der Last auszublenden, ist vorgesehen, die Überwachungseinrichtung mit einem Zeitglied auszubilden und den Gradienten des Spannungsanstiegs erst dann zu erfassen, wenn das Zeitglied abgelaufen ist.

Neben der Ermittlung und Überwachung des Gradienten des Spannungsanstiegs kann die Überwachungsvorrichtung eine Vergleichseinrichtung aufweisen, die die Eingangsspannung der Ansteuerschaltung mit einem vorgegebenen Spannungswert vergleicht. So ist die Möglichkeit gegeben, neben dem Gradienten des Spannungsanstiegs weitere Bedingungen abzufragen, die vor einer Wiederinbetriebnahme des Elektromotors erfüllt sein müssen.

Die Spannungsquelle ist zweckmäßig ein Akku, wobei die Akkuspannung größer als die Betriebsspannung des Elektromotors vorgesehen sein kann.

Weitere Merkmale der Erfindung ergeben sich aus den weiteren Ansprüchen, der Beschreibung und der Zeichnung, in der nachfolgend im Einzelnen beschriebene Ausführungsbeispiele der Erfindung dargestellt sind. Es zeigen:
- Fig. 1: in schematischer Seitenansicht ein tragbares, elektrisches Arbeitsgerät mit einem Akku,
- Fig. 2: eine schematische Darstellung eines Schaltplans zum Betrieb eines Elektromotors,
- Fig. 3: ein Ablaufdiagramm zur Inbetriebnahme des Elektromotors,
- Fig. 4: in schematischer Darstellung den Spannungsverlauf einer Eingangsspannung einer Ansteuerschaltung für den Elektromotor,
- Fig. 5: eine schematische Darstellung des Spannungsverlaufs gemäß Fig. 4 nach einer Abschaltung des Elektromotors unter Strom,
- Fig. 6: eine schematische Darstellung des Spannungsverlaufs der Eingangsspannung bei Auftreten einer Unterspannung.

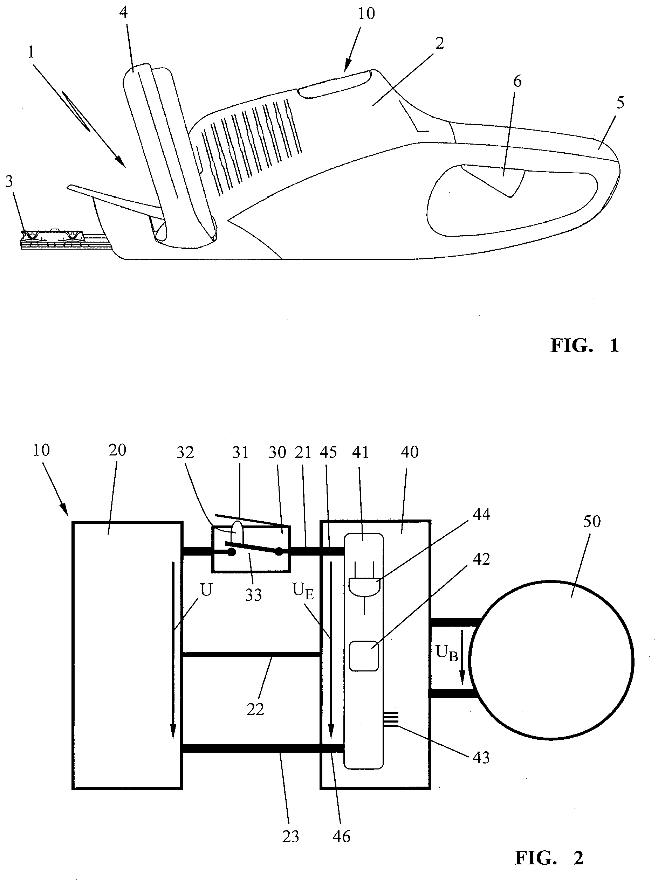

In Fig. 1 ist ein tragbares, handgeführtes Arbeitsgerät 1 gezeigt, welches im Ausführungsbeispiel als Heckenschere dargestellt ist. Das Arbeitsgerät 1 ist ein elektrisches Arbeitsgerät und wird von einem Akku 10 angetrieben, der in das Gehäuse 2 des Arbeitsgerätes eingeschoben ist. Das dargestellte Arbeitsgerät 1 weist ein Werkzeug 3 auf, welches von einem Elektromotor 50 (Fig. 2) angetrieben ist.

Das Arbeitsgerät 1 ist mit einem vorderen Handgriff 4 und einem hinteren Handgriff 5 ausgebildet, wobei im Ausführungsbeispiel im hinteren Handgriff 5 ein Betätigungsglied 6 für einen Betriebsschalter 30 (Fig. 2) vorgesehen ist.

Das Arbeitsgerät 1 kann auch als akkubetriebenes Blasgerät, akkubetriebener Freischneider, akkubetriebene Heckenschere oder dgl. akkubetriebenes Arbeitsgerät ausgeführt sein.

Wie Fig. 2 zeigt, bildet der Akku 10 eine Spannungsquelle 20 für das Arbeitsgerät 1. Die Spannungsquelle 20 stellt eine Versorgungsspannung U zur Verfügung, die über den Betriebsschalter 30 auf eine Ansteuerschaltung 40 geschaltet ist.

Im gezeigten Ausführungsbeispiel ist der Betriebsschalter 30 als Mikroschalter ausgebildet und umfasst einen Schalthebel 31, der auf einen Betätigungsstift 32 wirkt. An dem Schalthebel 31 greift das Betätigungsglied 6 des Arbeitsgerätes 1 an. Durch Niederdrücken des Betätigungsgliedes 6 wird der Schalthebel 31 bewegt und der als Schließer gestaltete Kontakt 33 geschlossen.

Bei geschlossenem Betriebsschalter 30 ist der Kontakt 33 geschlossen, so dass die Versorgungsspannung U der Spannungsquelle 20 über die Verbindungsleitungen 21, 23 an den Eingangsklemmen 45, 46 der Ansteuerschaltung 40 als Eingangsspannung U_{E} anliegt. Zur Kommunikation des Akkus 20 mit der Ansteuerschaltung 40 ist dieser ferner über zumindest eine Datenleitung 22 mit der Ansteuerschaltung 40 verbunden. Der Betriebsschalter 30 ist im gezeigten Ausführungsbeispiel in der Verbindungsleitung 21 vorgesehen, die vorzugsweise den Pluspol der Spannungsquelle 20 bildet.

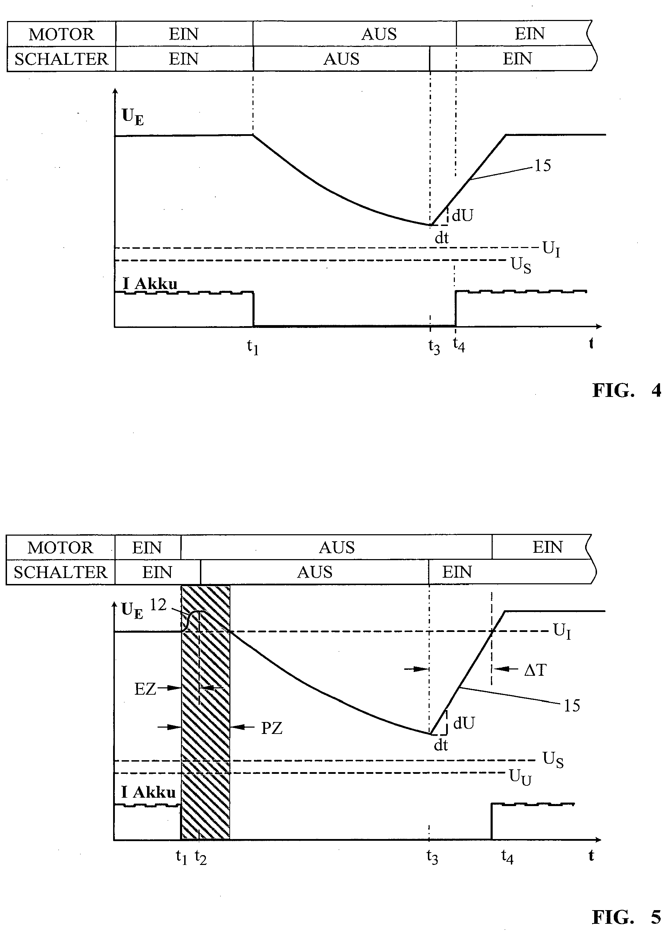

Zur Überwachung des Verlaufs der Eingangsspannung U_{E} ist eine Überwachungsvorrichtung 41 vorgesehen, der die Eingangsspannung U_{E} zugeführt ist. Die Überwachungsvorrichtung 41 überwacht einen Gradienten dU/dt des Spannungsanstiegs 15 der Eingangsspannung U_{E}, wie z. B. in Fig. 4 wiedergegeben. Der ermittelte Gradient dU/dt des Spannungsanstiegs 15 der Eingangsspannung U_{E} wird mit einem vorgegebenen Grenzwert verglichen. Überschreitet der ermittelte Gradient dU/dt den vorgegebenen Grenzwert, wird der Betriebsschalter 30 bzw. der Kontakt 33 des Betriebsschalters 30 als geschlossen erkannt und dies über eine Steuerleitung 43 der Ansteuerschaltung 40 gemeldet, damit diese den Elektromotor 50 in Betrieb nimmt.

Im Ausführungsbeispiel nach Fig. 2 ist die Überwachungsvorrichtung 41 als Teil der Ansteuerschaltung 40 ausgebildet. Vorteilhaft umfasst die Überwachungsvorrichtung 41 ein Zeitglied 42, welches z.B. eine Pausenzeit PZ vorgibt. Erst nach Ablauf der Pausenzeit PZ wird der Gradient dU/dt des Spannungsanstiegs 15 der Eingangsspannung U_{E} ausgewertet, wie in Figur 5 gezeigt. Dies ist insbesondere bei einem Abschalten des Elektromotors 50 aufgrund eines Fehlers oder Überlast zweckmäßig.

In Ergänzung kann die Überwachungsvorrichtung 41 mit einer Vergleichseinrichtung 44 versehen sein, die die an den Eingangsklemmen 45, 46 anliegende Eingangsspannung U_{E} mit einem vorgegebenen Spannungswert U_{I}, U_{S} und/oder U_{U} vergleicht, wie es nachstehend noch im Einzelnen beschrieben ist.

Im Ausführungsbeispiel nach Fig. 2 ist die Versorgungsspannung U größer als die dem Elektromotor 50 über die Ansteuerschaltung 40 zugeführte Betriebsspannung U_{B}. Die Ansteuerschaltung 40 variiert die Betriebsspannung U_{B} des Elektromotors 50 und passt diese an die zulässigen Größen an, z. B. durch eine Pulsweitenmodulation.

Die erfindungsgemäße Schaltungsanordnung gemäß Fig. 2 dient der Erkennung der Schaltstellung des Betriebsschalters 30 zur Inbetriebnahme des Elektromotors 50. Der Elektromotor 50 ist über die Ansteuerschaltung 40 mit der Spannungsquelle 20 verbunden, wobei die Versorgungsspannung U der Spannungsquelle als Eingangsspannung U_{E} auf die Ansteuerschaltung 40 aufgeschaltet ist.

Liegt - wie in Fig. 4 wiedergegeben - die Eingangsspannung U_{E} oberhalb einer Initialspannung U_{I}, wird ein geschlossener Betriebsschalter 30 dann erkannt, wenn der Gradient dU/dt eines Spannungsanstiegs 15 der Eingangsspannung U_{E} oberhalb eines vorgegebenen Grenzwertes liegt. Hierzu wird nach dem Abschalten des Elektromotors 50, der in seinen Schaltstellungen in Fig. 4 oben dargestellt ist, die Eingangsspannung U_{E} der Ansteuerschaltung 40 überwacht. Der Zustand des Betriebsschalters 30 ist in Fig. 4 in einem Balken oberhalb des Diagramms wiedergegeben.

Öffnet der Benutzer den Betriebsschalter 30 im Zeitpunkt t₁ so fällt - da die Versorgungsspannung U von den Eingangsklemmen 45/46 getrennt ist - die Eingangsspannung U_{E} ab. In Fig. 4 wird davon ausgegangen, dass die Eingangsspannung U_{E} nicht unterhalb einer Startspannung U_{S} bzw. einer Initialspannung U_{I} abfällt. Schaltet der Bediener durch Niederdrücken des Betätigungsgliedes 6 den Betriebsschalter 30 im Zeitpunkt t₃ erneut ein, wird die Eingangsspannung U_{E} ansteigen. Sobald ein Gradient dU/dt des Spannungsanstiegs 15 erkannt wird, der oberhalb eines vorgegebenen Grenzwertes liegt, wird der Elektromotor 50 im Zeitpunkt t₄ eingeschaltet. Der Betriebsschalter 30 bzw. dessen Kontakt 33 wurden über den Gradienten dU/dt als geschlossen erkannt und der Elektromotor 50 korrekt wieder in Betrieb genommen, wodurch ein rascherer Wiederanlauf des Elektromotors 50 gewährleistet ist.

Die Überwachung des Gradienten dU/dt des Spannungsanstiegs 15 kann bereits mit dem Ausschalten des Betriebsschalters 30 erfolgen, also sofort starten. Ein negativer Gradient dU/dt des Spannungsabfalls wird ignoriert. Nur ein positiver Gradient dU/dt des Spannungsanstiegs 15 wird mit dem vorgegebenen Grenzwert verglichen. Nur wenn ein positiver Gradient dU/dt festgestellt wird, ist dies ein Indikator für den Schaltzustand des Betriebsschalters.

Im Ausführungsbeispiel nach Fig. 5 ist ein Abschalten des Elektromotors 50 unter Strom wiedergegeben. Beispielsweise kann der Elektromotor 50 über eine Sicherheitsschaltung bei einer überhöhten Stromaufnahme aufgrund Blockierens des Werkzeugs 3 des Arbeitsgerätes 1 abgeschaltet werden. Wie im Zeitpunkt t₁ wiedergegeben, erfolgt nach dem Abschalten des Elektromotors 50 durch die Sicherheitsschaltung eine elektrochemische Erholung des Akkus 10, was zu einem Spannungsanstieg 12 führt. Erst mit dem Ausschalten des Betriebsschalters 30 im Zeitpunkt t₂ fällt die Eingangsspannung U_{E} entsprechend dem dargestellten Kennlinienverlauf. Damit ein positiver Gradienten dU/dt des Spannungsanstiegs 12 nicht zu einer fehlerhaften Erkennung des Schaltzustands des Betriebsschalters 30 führt, ist vorgesehen, dass nach dem Abschalten des Elektromotors 50 durch die Sicherheitsschaltung innerhalb einer Pausenzeit PZ der Gradient dU/dt eines Spannungsanstiegs 15 nicht ausgewertet bzw. nicht ermittelt wird. Die Pausenzeit PZ ist so gewählt, dass sie größer als die Erholzeit EZ des Akkus 10 ist. Der Beginn der Suche nach einem Gradienten dU/dt des Spannungsanstiegs 15 erfolgt, nachdem die Pausenzeit PZ verstrichen und die Startspannung Us überschritten ist, was im Beispiel nach Fig. 5 erfüllt ist.

Wird nach einem Öffnen des Betriebsschalters 30 der Betriebsschalter im Zeitpunkt t₃ erneut betätigt, erfolgt ab diesem Zeitpunkt t₃ ein Spannungsanstieg 15. Wird festgestellt, dass der nach dem Einschalten des Betriebsschalters 30 ermittelte Gradient dU/dt des Spannungsanstiegs 15 den vorgegebenen Grenzwert überschreitet, ist ein geschlossener Betriebsschalter erkannt und eine erste Bedingung für das Wiedereinschalten des Elektromotors 50 erfüllt. Die Erfüllung dieser ersten Bedingung für das Einschalten des Elektromotors 50 (Erkennung des geschlossenen Betriebsschalters 30 durch Überschreiten des vorgegebenen Grenzwerts des Spannungsanstiegs dU/dt) wird für einen bestimmten Zeitraum ΔT in einem Zwischenspeicher festgehalten. Die in Fig. 5 dargestellte weitere Bedingung für das Wiedereinschalten des Elektromotors 50 ist ein Überschreiten der Initialspannung U_{I}. Erst wenn die Überwachungsvorrichtung 41 mittels der Vergleichseinrichtung 44 ein Überschreiten eines vorgegebenen initialen Spannungswertes U_{I} feststellt, wird der Elektromotor 50 in Betrieb genommen. Dabei ist vorgesehen, dass das Überschreiten des ermittelten Gradienten dU/dt des Spannungsanstiegs 15 über den vorgegebenen Grenzwert und das Überschreiten der vorgegebenen Initialspannung Ui innerhalb eines vorgegebenen Zeitraums ΔT liegt. Es hat sich als zweckmäßig erwiesen, wenn sich der Zeitraum ΔT über einen Zeitraum von 80 bis 200 Millisekunden erstreckt. Vorteilhaft beträgt der Zeitraum ΔT 100 Millisekunden.

Wird nach Ablauf des Zeitraums ΔT zumindest eine der beiden Bedingungen (Überschreiten des Grenzwertes des Gradienten dU/dt des Spannungsanstiegs 15 und/oder das Überschreiten des vorgegebenen Initialwertes U_{I}) nicht festgestellt, erfolgt kein Wiedereinschalten des Elektromotors 50.

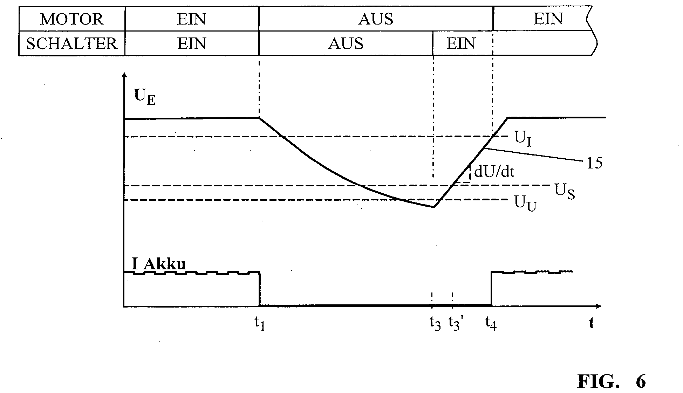

In Fig. 6 ist ein Auslaufen des Elektromotors 50 nach Ausschalten des Betriebsschalters 30 gezeigt. In Fig. 6 wird davon ausgegangen, dass die Eingangsspannung U_{E} nach Öffnen des Betriebsschalters 30 im Zeitpunkt t₁ bis unter eine Unterspannung Uu abfällt. Schaltet der Benutzer im Zeitpunkt t₃ den Betriebsschalter 30 erneut ein, steigt die Eingangsspannung U_{E} wieder an bis zunächst die Unterspannung Uu überschritten und folgend eine Startspannung Us zum Wiederanlauf des Elektromotors 50 überschritten ist. Zweckmäßig erfolgt erst nach diesem Zeitpunkt t'₃ die erfindungsgemäße Überwachung der Eingangsspannung U_{E} der Ansteuerschaltung 40 in Bezug auf den Gradienten dU/dt des Spannungsanstiegs 15. Entsprechend der Darstellung des Spannungsverlaufs in Fig. 5 muss nach Überschreiten der Startspannung U_{S} zunächst ein Gradient dU/dt des Spannungsanstiegs 15 ermittelt werden, der größer als ein vorgegebener Grenzwert ist. Weiter muss die Bedingung erfüllt sein, dass die Initialspannung U_{I} vor einem Wiedereinschalten des Elektromotors 50 im Zeitpunkt t₄ überschritten ist. Der Gradient dU/dt des Spannungsanstiegs 15 ist ab dem Beginn des Überschreitens der Startspannung U_{S} bis zum Überschreiten der Initialspannung U_{I} zu ermitteln. Sobald der Anstieg des Gradienten dU/dt über einen vorgegebenen Grenzwert erkannt wir, wir dieses zwischengespeichert. Wird während dieses Zeitraums t₃ bis t₄ kein Gradient dU/dt des Spannungsanstiegs 15 festgestellt, der den vorgegebenen Grenzwert überschreitet, wird der Elektromotor 50 nicht in Betrieb genommen.

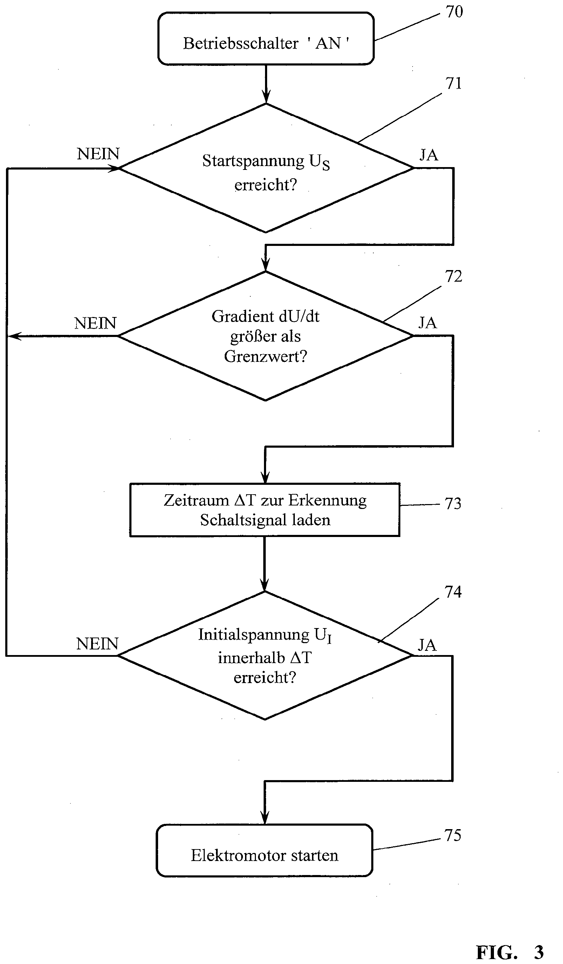

In Fig. 3 ist der Ablauf eines Ausführungsbeispiels des erfindungsgemäßen Verfahrens wiedergegeben. Feld 70 gibt an, dass der Betriebsschalter 30 - nach einem Ausschalten - wieder eingeschaltet ist (AN). In einem ersten Feld 71 wird abgefragt, ob die Eingangsspannung U_{E} die Startspannung Us für einen Wiederanlauf des Elektromotors 50 erreicht hat. Dies ist entsprechend in Fig. 6 dargestellt.

Ist dieses der Fall, liegt also die Eingangsspannung U_{E} oberhalb einer vorgegebenen Startspannung Us, wird der Gradient dU/dt des Spannungsanstiegs 15 der Eingangsspannung U_{E} ermittelt und überprüft, ob dieser größer als ein vorgegebener Grenzwert ist (Feld 72). Trifft dieses zu, erfolgt im Feld 73 die Ladung eines vorgegebenen Zeitraums ΔT, innerhalb dem die Erkennung des Schaltsignals zum Einschalten des Elektromotors 50 liegen muss.

Danach erfolgt im Feld 74 die Abfrage, ob die Initialspannung U_{I} innerhalb des Zeitfenster ΔT erreicht wurde. Ist dieses der Fall, wird im Feld 75 der Elektromotor 50 gestartet. Treffen die in den Feldern 72 und 74 genannten Bedingungen nicht zu, wird über den NEIN-Zweig zurück auf das Feld 71 verzweigt. Wird z. B. nach der Erkennung des Gradienten dU/dt die Initialspannung Ui innerhalb des Zeitfenster ΔT nicht erreicht, wird über den NEIN-Pfad zum Eingang des Feldes 71 zurück verzweigt.

## Patentansprüche

1. Verfahren zur Erkennung der Schaltstellung eines Betriebsschalters (30) zur Inbetriebnahme eines Elektromotors (50), wobei der Elektromotor (50) über eine Ansteuerschaltung (40) mit einer Spannungsquelle (20) verbunden ist, und zwischen der Ansteuerschaltung (40) und der Spannungsquelle (20) der Betriebsschalter (30) angeordnet ist, der die Versorgungsspannung (U) der Spannungsquelle (20) als Eingangsspannung (U_{E}) auf die Ansteuerschaltung (40) schaltet,
**dadurch gekennzeichnet,**
a. **dass** nach einem Abschalten des Elektromotors (50) die Eingangsspannung (U_{E}) der Ansteuerschaltung (40) überwacht wird,
b. **dass** ein Gradient (dU/dt) eines Spannungsanstiegs (15) der Eingangsspannung (U_{E}) ermittelt wird,
c. **dass** der ermittelte Gradient (dU/dt) des Spannungsanstiegs (15) der Eingangsspannung (U_{E}) mit einem vorgegebenen Grenzwert verglichen wird,
d. und **dass** bei Überschreiten des vorgegebenen Grenzwertes der Betriebsschalter (30) als geschlossen erkannt und der Elektromotor (50) über die Ansteuerschaltung (40) erneut in Betrieb genommen wird.

2. Verfahren nach Anspruch 1,
**dadurch gekennzeichnet, dass** die erneute Inbetriebnahme des Elektromotors (50) nach einem Öffnen des Betriebsschalters (30) erfolgt.

3. Verfahren nach Anspruch 1 oder 2,
**dadurch gekennzeichnet, dass** erst nach einem Überschreiten eines vorgegebenen Spannungswertes (U_{I}) der Elektromotor (50) über die Ansteuerschaltung (40) in Betrieb genommen wird.

4. Verfahren nach Anspruch 3,
**dadurch gekennzeichnet, dass** das Überschreiten des ermittelten Gradienten (dU/dt) des Spannungsanstiegs (15) über den vorgegebenen Grenzwert und das Überschreiten des vorgegebenen Spannungswertes (U_{I}) innerhalb eines vorgegebenen Zeitfensters (ΔT) liegt.

5. Verfahren nach Anspruch 4,
**dadurch gekennzeichnet, dass** sich das Zeitfenster (ΔT) über einen Zeitraum von 80 bis 200 Millisekunden erstreckt, insbesondere 100 Millisekunden beträgt.

6. Verfahren nach Anspruch 5,
**dadurch gekennzeichnet, dass** nach Ablauf des Zeitfensters (ΔT) die Ansteuerschaltung (40) resettet wird.

7. Verfahren nach Anspruch 1,
**dadurch gekennzeichnet, dass** der Spannungsanstieg (15) der Eingangsspannung (U) erst nach Ablauf einer Pausenzeit (PZ) nach einem Abschalten des Elektromotors (50) ermittelt wird.

8. Verfahren nach Anspruch 7,
**dadurch gekennzeichnet, dass** die Spannungsquelle (20) ein Akku (10) ist und die Pausenzeit (PZ) größer als die Erholzeit (EZ) des Akkus (10) gewählt wird.

9. Verfahren nach Anspruch 1,
**dadurch gekennzeichnet, dass** nach dem Öffnen des Betriebsschalters (30) die Eingangsspannung (U_{E}) der Ansteuerschaltung (40) über einen Zeitraum von 1 bis 4 Sekunden unter einen vorgegebenen Grenzwert (U_{S}) abfällt, insbesondere auf Null abfällt.

10. Vorrichtung zur Erkennung der Schaltstellung eines Betriebsschalters (30) zur Inbetriebnahme eines Elektromotors (50), wobei der Elektromotor (50) über eine Ansteuerschaltung (40) mit einer Spannungsquelle (20) verbunden ist, und der Betriebsschalter (30) zwischen der Ansteuerschaltung (40) und der Spannungsquelle (20) angeordnet ist, wobei der Betriebsschalter (30) die Versorgungsspannung (U) der Spannungsquelle (20) als Eingangsspannung (U_{E}) auf die Ansteuerschaltung (40) schaltet,
**dadurch gekennzeichnet, dass** eine Überwachungsvorrichtung (41) vorgesehen ist, an der die Eingangsspannung (U_{E}) der Ansteuerschaltung (40) anliegt, dass die Überwachungsvorrichtung (41) einen Gradienten (dU/dt) des Spannungsanstiegs (15) der Eingangsspannung (U_{E}) überwacht, und die Überwachungsvorrichtung (41) den ermittelten Gradienten (dU/dt) mit einem vorgegebenen Grenzwert vergleicht, und bei Überschreiten des vorgegebenen Grenzwertes der Betriebsschalter (30) als geschlossen erkannt und der Ansteuerschaltung (40) über zumindest eine Steuerleitung (43) ein Startsignal übermittelt wird, um den Elektromotor (50) über die Ansteuerschaltung (40) erneut in Betrieb zu nehmen.

11. Vorrichtung nach Anspruch 10,
**dadurch gekennzeichnet, dass** die Überwachungsvorrichtung (41) ein Zeitglied (42) umfasst, und der Gradient (dU/dt) des Spannungsanstiegs (15) der Eingangsspannung (U_{E}) erst nach Ablauf des Zeitgliedes (42) erfasst wird.

12. Vorrichtung nach Anspruch 10,
**dadurch gekennzeichnet, dass** die Überwachungsvorrichtung (41) eine Vergleichseinrichtung (44) umfasst, die die Eingangsspannung (U_{E}) mit einem vorgegebenen Spannungswert (U_{I}, U_{S}, U_{U}) vergleicht.

13. Vorrichtung nach Anspruch 10,
**dadurch gekennzeichnet, dass** die Spannungsquelle (20) ein Akku (10) ist.

14. Vorrichtung nach Anspruch 13,
**dadurch gekennzeichnet, dass** die Akkuspannung (U) größer als die Betriebsspannung (U_{B}) des Elektromotors (50) ist.

## Claims

1. Method for detecting the switching position of an operating switch (30) for starting an electric motor (50), wherein the electric motor (50) is connected to a voltage source (20) via a drive circuit (40) and the operating switch (30), which switches the supply voltage (U) of the voltage source (20) as an input voltage (U_{E}) onto the drive circuit (40), is located between the drive circuit (40) and the voltage source (20),
**characterised in that**
a) after a switch-off of the electric motor (50), the input voltage (U_{E}) of the drive circuit (40) is monitored,
b) a gradient (dU/dt) of a voltage increase (15) of the input voltage (U_{E}) is determined,
c) the determined gradient (dU/dt) of the voltage increase (15) of the input voltage (U_{E}) is compared to a preset limit value, and
d) if the preset limit value is exceeded, the operating switch (30) is deemed closed and the electric motor (50) can be restarted via the drive circuit (40).

2. Method according to claim 1,
**characterised in that** the electric motor (50) is restarted after an opening of the operating switch (30),

3. Method according to claim 1 or 2,
**characterised in that** the electric motor (50) is started via the drive circuit (40) only after a preset voltage value (Ui) has been exceeded.

4. Method according to claim 3,
**characterised in that** the exceeding of the determined gradient (dU/dt) of the voltage increase (15) above the preset limit value and the exceeding of the preset voltage value (Ui) lie within a preset time window (ΔT).

5. Method according to claim 4,
**characterised in that** the time window (ΔT) extends over a period of 80 to 200 milliseconds, being 100 milliseconds in particular.

6. Method according to claim 5,
**characterised in that** the drive circuit (40) is reset on expiry of the time window (ΔT).

7. Method according to claim 1,
**characterised in that** the voltage increase (15) of the input voltage (U) is only determined on expiry of a pause time (PZ) after a switch-off of the electric motor (50).

8. Method according to claim 7,
**characterised in that** the voltage source (20) is a battery (10) and the pause time (PZ) is longer than the recovery time of the battery (10).

9. Method according to claim 1,
**characterised in that** following the opening of the operating switch (30), the input voltage (U_{E}) of the drive circuit (40) falls below a preset limit value (Us), in particular to zero, over a period of 1 to 4 seconds.

10. Device for detecting the switching position of an operating switch (30) for starting an electric motor (50), wherein the electric motor (50) is connected to a voltage source (20) via a drive circuit (40) and the operating switch (30) is located between the drive circuit (40) and the voltage source (20), wherein the operating switch (30) switches the supply voltage (U) of the voltage source (20) as an input voltage (U_{E}) onto the drive circuit (40),
**characterised in that** a monitoring device (41), to which the input voltage (U_{E}) of the drive circuit (40) is applied, is provided, **in that** the monitoring device (41) monitors a gradient (dU/dt) of the voltage increase (15) of the input voltage (U_{E}) and the monitoring device (41) compares the determined gradient (dU/dt) to a preset limit value and, if the preset limit value is exceeded, the operating switch (30) is deemed closed and the drive circuit (40) receives a start signal via at least one control line (43) for restarting the electric motor (50) via the drive circuit (40).

11. Device according to claim 10,
**characterised in that** the monitoring device (41) comprises a timing element (42) and the gradient (dU/dt) of the voltage increase (15) of the input voltage (U_{E}) is only determined on expiry of the timing element (42).

12. Device according to claim 10,
**characterised in that** the monitoring device (41) comprises a comparison device (44), which compares the input voltage (U_{E}) to a preset voltage value (U_{I}, U_{S}, U_{U}).

13. Device according to claim 10,
**characterised in that** the voltage source (20) is a battery (10).

14. Device according to claim 13,
**characterised in that** the battery voltage (U) is higher than the operating voltage (U_{B}) of the electric motor (50).

## Revendications

1. Procédé pour détecter la position de commutation d'un commutateur de fonctionnement (30) pour la mise en marche d'un moteur électrique (50), le moteur électrique (50) étant relié par l'intermédiaire d'un circuit de commande (40) à une source de tension (20), et entre le circuit de commande (40) et la source de tension (20) étant disposé le commutateur de fonctionnement (30) qui transmet la tension d'alimentation (U) de la source de tension (20) comme tension d'entrée (U_{E}) au circuit de commande (40),
**caractérisé**
a. **en ce qu'**après un arrêt du moteur électrique (50), la tension d'entrée (U_{E}) du circuit de commande (40) est surveillée,
b. **en ce qu'**un gradient (dU/dt) d'une augmentation (15) de la tension d'entrée (U_{E}) est déterminé,
c. **en ce que** le gradient (dU/dt) déterminé de l'augmentation (15) de la tension d'entrée (U_{E}) est comparé à une valeur seuil prédéfinie,
d. **en ce que** dans le cas d'un dépassement de la valeur seuil prédéfinie, le commutateur de fonctionnement (30) est jugé fermé, et le moteur électrique (50) est remis en marche par l'intermédiaire du circuit de commande (40).

2. Procédé selon la revendication 1,
**caractérisé en ce que** la remise en marche du moteur électrique (50) se fait après une ouverture du commutateur de fonctionnement (30).

3. Procédé selon la revendication 1 ou 2,
**caractérisé en ce que** le moteur électrique n'est mis en marche par l'intermédiaire du circuit de commande qu'après un dépassement d'une valeur de tension (Ui) prédéfinie.

4. Procédé selon la revendication 3,
**caractérisé en ce que** le dépassement du gradient (dU/dt) déterminé de l'augmentation de tension (15) est situé au-dessus de la valeur seuil prédéfinie, et le dépassement de la valeur de tension (U_{I}) prédéfinie est situé à l'intérieur d'un intervalle de temps (ΔT) prédéfini.

5. Procédé selon la revendication 4,
**caractérisé en ce que** l'intervalle de temps (ΔT) s'étend sur une période de 80 à 200 millisecondes, et est en particulier de 100 millisecondes.

6. Procédé selon la revendication 5,
**caractérisé en ce qu'**après écoulement de l'intervalle de temps (ΔT), le circuit de commande (40) est réinitialisé.

7. Procédé selon la revendication 1,
**caractérisé en ce que** l'augmentation (15) de la tension d'entrée (U) n'est déterminée qu'après écoulement d'un temps de pause (PZ) après un arrêt du moteur électrique (50).

8. Procédé selon la revendication 7,
**caractérisé en ce que** la source de tension (20) est un accumulateur (10), et le temps de pause (PZ) est supérieur au temps de récupération (EZ) de l'accumulateur (10).

9. Procédé selon la revendication 1,
**caractérisé en ce qu'**après l'ouverture du commutateur de fonctionnement (30), la tension d'entrée (U_{E}) du circuit de commande (40), sur une période de 1 à 4 secondes, baisse jusqu'à une valeur inférieure à une valeur seuil prédéfinie (Us), et baisse en particulier jusqu'à zéro.

10. Dispositif pour détecter la position de commutation d'un commutateur de fonctionnement (30) pour la mise en marche d'un moteur électrique (50), le moteur électrique (50) étant relié par l'intermédiaire d'un circuit de commande (40) à une source de tension (20), et le commutateur de fonctionnement (30) étant disposé entre le circuit de commande (40) et la source de tension (20), et ledit commutateur de fonctionnement transmettant la tension d'alimentation (U) de la source de tension (20) comme tension d'entrée (U_{E}) au circuit de commande (40),
**caractérisé en ce qu'**il est prévu un dispositif de surveillance (41) auquel est appliquée la tension d'entrée (U_{E}) du circuit de commande (40), **en ce que** le dispositif de surveillance (41) surveille un gradient (dU/dt) de l'augmentation (15) de la tension d'entrée (U_{E}), et le dispositif de surveillance (41) compare le gradient (dU/dt) déterminé à une valeur seuil prédéfinie, et en cas de dépassement de la valeur seuil prédéfinie, le commutateur de fonctionnement (30) est jugé fermé, et un signal de démarrage est transmis au circuit de commande (40) par l'intermédiaire d'au moins une ligne de commande (43) afin de remettre le moteur électrique (50) en marche par l'intermédiaire du circuit de commande (40).

11. Dispositif selon la revendication 10,
**caractérisé en ce que** le dispositif de surveillance (41) comprend un élément de temporisation (42), et le gradient (dU/dt) de l'augmentation (15) de la tension d'entrée (U_{E}) n'est détecté qu'après écoulement dudit élément de temporisation (42).

12. Dispositif selon la revendication 10,
**caractérisé en ce que** le dispositif de surveillance (41) comprend un dispositif de comparaison (44) qui compare la tension d'entrée (U_{E}) à une valeur de tension prédéfinie (U_{I}, U_{S}, U_{U}).

13. Dispositif selon la revendication 10,
**caractérisé en ce que** la source de tension (20) est un accumulateur (10).

14. Dispositif selon la revendication 13,
**caractérisé en ce que** la tension d'accumulateur (U) est supérieure à la tension de fonctionnement (U_{B}) du moteur électrique (50).
